# EUROPÄISCHE PATENTSCHRIFT

(11) **EP 1 787 325 B1**
(45) Veröffentlichungstag und Bekanntmachung des Hinweises auf die Patenterteilung: **24.06.2009**
(21) Anmeldenummer: 05763082.4
(22) Anmeldetag: 12.07.2005
(51) Int. Cl.: H01L 23/40

(54) **BAUGRUPPE**
SUB-ASSEMBLY
CONSTRUCTION MODULAIRE

(30) Priorität: 06.09.2004 DE 102004043019
(43) Veröffentlichungstag der Anmeldung: 23.05.2007
(73) Patentinhaber: Infineon Technologies AG, 85579 Neubiberg (DE)
(72) Erfinder: STOLZE, Thilo, 59759 Arnsberg (DE); BÖTTCHER, Richard, 59581 Warstein (DE)
(74) Vertreter: Schmuckermaier, Bernhard
(86) Internationale Anmeldenummer: PCT/EP2005/007514
(87) Internationale Veröffentlichungsnummer: WO 2006/027040

(56) Entgegenhaltungen:
- EP-A- 0 295 387
- EP-A- 0 434 298
- DE-A1- 10 142 971
- DE-A1- 10 149 886
- DE-A1- 19 942 915

## Beschreibung

Die Erfindung betrifft ein Leistungshalbleitermodul mit einer Wärmeableitkontaktfläche zur wärmeleitenden Verbindung mit einem Kühlelement.

Ein derartiger Modulaufbau ist üblich und z.B. aus der DE 199 42 915 A1 bekannt. Dieses bekannte Modul umfasst einen isolierenden und thermisch leitenden Träger (Substrat), der z.B. aus einem keramischen, beidseitig z.B. Kupferbeschichteten (DCB) Material besteht. In der Oberseitenbeschichtung sind Leiterbahnstrukturen ausgebildet, mit denen mehrere Leistungshalbleiter elektrisch verbunden sind. Die Substratunterseite fungiert als Wärmeableitkontaktfläche, um beim Betrieb in Form von Wärme auftretende Verlustleistungen an einen Kühlkörper abführen zu können. Dazu ist eine mehrere Substrate übergreifende Anpressvorrichtung vorgesehen mit Druckstücken, die sowohl zur elektrischen Kontaktierung dienen als auch die Substrate auf den Kühlkörper pressen.

In der EP 0 295 387 A2 ist ein Elektronikmodul beschrieben, das mittels einer Federklammer an einen Kühlkörper gepresst wird. Nachdem das Elektronikmodul an seiner Oberseite mit einem Kühlkörper verbunden ist, wird die Klammer.auf den Kühlkörper aufgesetzt und greift in eine Aussparung des Gehäuses des Elektronikmoduls. Die Klammer liegt in der Aussparung auf einem wärmeleitenden Streifen auf, der mit Leistungshalbleiterbauelementen wärmeleitend verbunden ist. Im montierten Zustand stellt die Klammer eine zusätzliche Wärmeleitung zwischen den Bauelementen und dem Kühlelement sicher.

In EP 0 434 298 A1, ist ein Elektronikmodul in Form eines flachen Plastikmoduls beschrieben. Zur Herstellung einer Verbindung zwischen dem Modul und einem Kühlkörper sind an den Aussenkanten auf der Oberseite des Moduls hervorgehobene Bereiche integral ausgebildet, die in Aussparungen in dem Kühlkörper im montierten Zustand eingreifen. Nachteilig bei der in EP 0 434 298 A1 beschriebenen Anordnung ist, dass im montierten Zustand durch den starren Kühlkörper auf das Gehäuse des Moduls ausgeübte Kräfte zu unerwünschten mechanischen Spannungen im Modulgehäuse führen, die sich nachteilig auf das Bauelementverhalten auswirken können,

Aus der DE 101 49 886 A1 ist ein Leistungshalbleitermodul bekannt, das mittels federelastischer Bereiche eines zweiteiligen Modulgehäuses an einen Kühlkörper gepresst wird. Die auf das Leistungshalbleitermodul wirkende Anpresskraft an den Kühlkörper wird dadurch erzeugt, dass der Teil des Modulgehäuses, der die federelastischen Bereiche aufweist, mit dem Kühlkörper verschraubt wird.

Die DE 297 20 480 U1 und DE 200 14 739 U1 zeigen Anpresselemente in Form eines Bügels, der mit mindestens einem Befestigungsbereich mit dem Kühlelement formschlüssig (DE 297 20 480 U1) oder durch Verschraubung verbunden (DE 200 14 739 U1) ist. Der Bügel presst mit einem Andruckbereich das zu kühlende Bauteil mit seiner Wärmeableitkontaktfläche auf das Kühlelement.

Die Montage des bekannten Leistungshalbleitermoduls auf dem Kühlelement ist aufwendig und kostenintensiv, weil im Montageprozess das oder die Anpresselement(e) separat gehandhabt, zugeführt und montiert werden muss/müssen, Je nach Ausgestaltung des Leistungshalbleitermoduls und des Anpresselements können dabei - z.B. durch mangelhafte Positionierung oder Ausrichtung - Montagefehler auftreten, die die Kühlwirkung und damit die Betriebssicherheit beeinflussen. Außerdem birgt die Verbindung zwischen Leistungshalbleitermodul und Anpresselement Maßtoleranzen, die sich unvorhersehbar auf die Größe der ausgeübten Anpresskräfte auswirken.

Der vorliegenden Erfindung liegt daher die Aufgabe zugrunde, ein Leistungshalbleitermodul der eingangs genannten Art derart auszugestalten, dass eine einfache, kostengünstig herstellbare und zuverlässige Befestigung an und Wärmeleitung zu einem Kühlelement sichergestellt ist.

Diese Aufgabe wird erfindungsgemäß durch ein Leistungshalbleitermodul nach dem Anspruch 1 gelöst. Ausgestaltungen und Weiterbildungen sind Gegenstand von Unteransprüchen.

Dabei ist mindestens ein Anpresselement vorgesehen, das unverlierbar mit dem Leistungshalbleitermodul verbunden ist. Dieses Anpresselement presst im montierten Zustand die Wärmeableitkontaktfläche an das Kühlelement, so dass der gewünschte zuverlässige wärmeleitende Kontakt zwischen Leistungshalbleitermodul und Kühlelement sichergestellt ist.

Ein erster wesentlicher Aspekt der vorliegenden Erfindung besteht darin, dass das Anpresselement bei der Verbindung eines Moduls mit einem Kühlelement nicht separat geliefert, bevorratet, gehandhabt, zugeführt und schließlich am Leistungshalbleitermodul montiert werden muss. Da das Anpresselement als integraler, unverlierbar mit dem Leistungshalbleitermodul verbundenes Element ausgestaltet ist, bildet es in vorteilhafter Weise eine (insoweit vorgefertigte) Baugruppe zur einfachen und kostengünstigen Montage auf bzw. Verbindung mit dem Kühlelement. Da die Verbindung zwischen Leistungshalbleitermodul und Anpresselement (automatisiert) vorgefertigt ist, können auch wesentlich geringere Toleranzen eingehalten werden, so dass sich die die Anpresskräfte bestimmende Toleranzkette Leistungshalbleitermodul-Anpresselement-Kühlelement reduziert.

Ein weiterer Vorteil besteht darin, dass herstellerseitig geeignet dimensionierte Anpresselemente fest zugeordnet und vorgegeben werden können. Bei der Montage steht also der Anwender nicht vor der Aufgabe, geeignete Anpresselemente dimensionieren oder zuordnen zu müssen. Verschiedene Leistungshalbleitermodule (z.B. mit unterschiedlicher Leistung) können so mit einheitlichen Anpresselementen versehen sein, was Vorratshaltung und Logistik weiter vereinfacht.

Eine bevorzugte Ausgestaltung der Erfindung sieht vor, dass das Anpresselement eine federnde Klammer ist, die vorteilhafterweise besonders einfach herstellbar ist.

Bei einer konstruktiv und fertigungstechnisch bevorzugten Ausgestaltung des erfindungsgemäßen Leistungshalbleitermoduls ist das Anpresselement mit einem Ankerbereich in dem Leistungshalbleitermodul verankert. Besonders bevorzugt ist der Ankerbereich in das Material eines Spritzgussgehäuses des Leistungshalbleitermoduls eingespritzt.

Die Erfindung wird nachfolgend anhand einer Zeichnung beispielhaft weiter erläutert; es zeigen:
- Figur 1: schematisch ein erfindungsgemäßes Leistungshalblei- termodul im Längsschnitt und
- Figur 2: das Modul in Aufsicht.

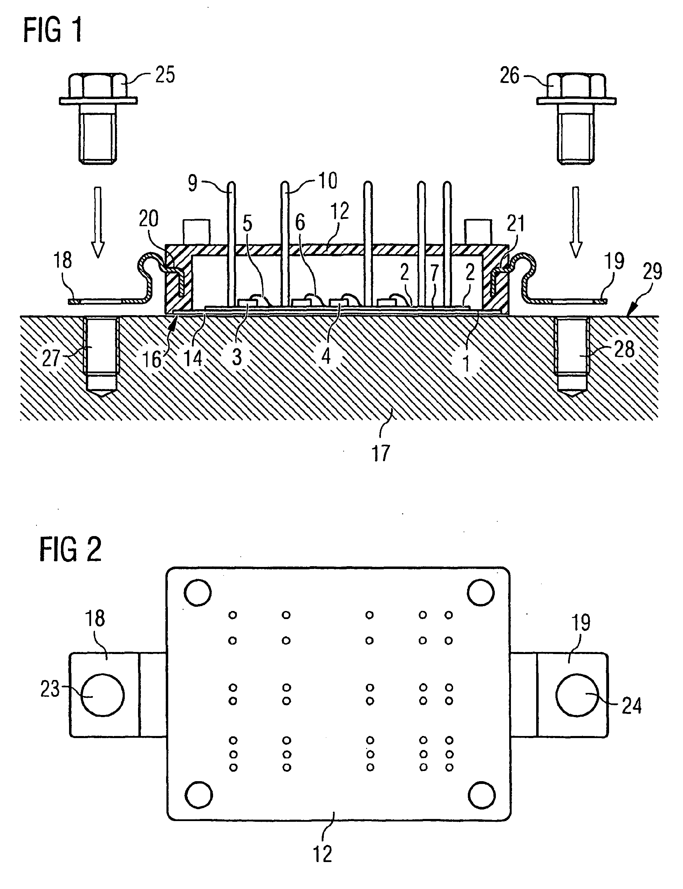

Figur 1 zeigt ein Leistungshalbleitermodul mit einem Substrat 1, das als beidseitig Kupfer-beschichtetes (DCB) Keramikplättchen ausgeführt ist. Auf der Oberseite 2 sind in an sich bekannter Weise mehrere Leistungshalbleiter 3, 4 angeordnet und durch fußseitige Lötung und/oder Bonddrähte 5, 6 mit auf der Oberseite ausgebildeten Leiterbahnen 7 verbunden. Nach oben erstrecken sich außerdem elektrische Anschlusskontakte, z.B. 9, 10. Das Substrat 1 und die Leistungshalbleiteranordnung sind von einem Kunststoffgehäuse 12 bedeckt, das im Spritzguss hergestellt ist. Die Unterseite 14 des Substrats bildet gleichzeitig die untere Außenfläche und dient durch ihre - vollflächig ausgebildete - Kupferbeschichtung als Wärmeableitkontaktfläche 16 zur wärmeleitenden Verbindung mit einem Kühlelement 17.

In das Gehäuse 12 sind beidseitig jeweils klammerförmig ausgeformte Anpresselemente 18, 19 mit jeweils einem Verankerungsbereich 20, 21 eingespritzt. Das Gehäusematerial (Kunststoff) umgibt somit die Verankerungsbereiche und sorgt für einen festen, unverlierbaren Sitz der Anpresselemente. Die Anpresselemente werden so schon in einem sehr frühen Fertigungsstadium - vorzugsweise beim Herstellen des Gehäuses 12 - integrale Bestandteile des Leistungshalbleitermoduls. Die Anpresselemente können dazu als Einlegeteile in das Kunststoffspritzguss-Werkzeug für das Gehäuse eingelegt und in einem einzigen - zur Gehäuseherstellung ohnehin erforderlichen - Spritzgussvorgang integriert werden.

Figur 2 zeigt zur Verdeutlichung die Anordnung und Ausgestaltung der Anpresselemente 18, 19 in Aufsicht. Hier ist eine symmetrische Anordnung der Anpresselemente gewählt; dies ist jedoch nicht zwingend. Es sind ebenso asymmetrische Gestaltungen oder auch - je nach gewünschter Andruckkraft - nur ein Anpresselement oder mehr als zwei Anpresselemente denkbar. Die Anpresselemente haben Bohrungen 23, 24, durch die Befestigungsschrauben 25, 26 (Figur 1) zur lösbaren Montage des Moduls auf dem Kühlelement hindurch greifen können.

Wie Pfeile (Figur 1) andeuten, werden die Anpresselemente durch die in Gewindebohrungen 27, 28 greifenden Schrauben 24, 25 auf die Kühlelementoberseite 29 gedrückt. Dabei erzeugen die Anpresselemente aufgrund ihrer federelastischen Eigenschaften die gewünschten homogenen Anpresskräfte.

Das erfindungsgemäße Leistungshalbleitermodul kombiniert also die Vorteile der durch Anpresselemente bzw. federnde Klammern erzeugbaren Andruckeigenschaften mit einer einfachen und kostengünstigen Realisierung der Verbindung mit dem Kühlelement.

### Bezugszeichenliste:

- 1: Substrat
- 2: Oberseite
- 3: Leistungshalbleiter
- 4: Leistungshalbleiter
- 5: Bonddraht
- 6: Bonddraht
- 7: Leiterbahn
- 9: Anschlusskontakt
- 10: Anschlusskontakt
- 12: Kunststoffgehäuse
- 14: Unterseite
- 16: Wärmeableitkontaktfläche
- 17: Kühlelement
- 18: Anpresselement
- 19: Anpresselement
- 20: Verankerungsbereich
- 21: Verankerungsbereich
- 23: Bohrung
- 24: Bohrung
- 25: Befestigungsschraube
- 26: Befestigungsschraube
- 27: Gewindebohrung
- 28: Gewindebohrung
- 29: Kühlelementoberseite

## Patentansprüche

1. Leistungshalbleitermodul mit
einer Wärmeableitkontaktfläche (16) zur wärmeleitenden Verbindung mit einem Kühlelement (17)
**gekennzeichnet durch**
mindestens ein Anpresselement (18, 19), das unverlierbar mit dem Leistungshalbleitermodul verbunden ist und
das im montierten Zustand die Wärmeableitkontaktfläche (16) an das Kühlelement (17) presst, wobei
das Leistungshalbleitermodul ein Spritzgussgehäuse (12) aufweist und
ein Ankerbereich (20, 21) des Anpresselements (18, 19) von Material des Spritzgussgehäuses (12) umspritzt ist,
wobei das Anpresselement (18, 19) mit dem Ankerbereich (20, 21) in dem leishergshalbleitermodul verankert ist.

2. Leistungshalbleitermodul nach Anspruch 1,
**dadurch gekennzeichnet, dass**
das Anpresselement (18, 19) eine federnde Klammer ist.

## Claims

1. Power semiconductor module comprising
a heat-dissipation contact area (16) for thermally conductive connection to a cooling element (17),
**characterized by**
at least one press-on element (18, 19) which is captively connected to the power semiconductor module and
which presses the heat-dissipation contact area (16) onto the cooling element (17) in the mounted state, the power semiconductor module having an injection-moulding housing (12), and
an anchoring region (20, 21) of the press-on element (18, 19) being encapsulated by the material of the injection-moulding housing (12) by injection moulding, the press-on element (18,19) being anchored with the anchoring region (20 ,21) in the power semiconductor module.

2. Power semiconductor module according to Claim 1,
**characterized in that**
the press-on element (18, 19) is a resilient clamp.

## Revendications

1. Module de semi-conducteur de puissance comprenant
une surface (16) de contact d'évacuation de la chaleur pour la liaison d'une manière conductrice de la chaleur avec un élément (17) de refroidissement
**caractérisé par**
au moins un élément (18, 19) d'application d'une pression, qui est relié d'une manière imperdable au module de semi-conducteur de puissance et
qui, à l'état monté, presse la surface (16) de contact d'évacuation de la chaleur sur l'élément (17) de refroidissement, dans lequel
le module de semi-conducteur de puissance a un boîtier (12) moulé par injection et
une partie (20, 21) d'ancrage de l'élément (18, 19) d'application d'une pression est couverte par extrusion par le matériau du boîtier (12) moulé par injection,
l'élément (18, 19) d'application d'une pression étant ancré par la partie (20, 21) d'ancrage dans le module de semi-conducteur de puissance.

2. Module de semi-conducteur de puissance suivant la revendication 1, **caractérisé en ce que** l'élément (18, 19) d'application d'une pression est une agrafe élastique.
